(19) Europäisches Patentamt / European Patent Office / Office européen des brevets

(11) **EP 1 340 230 B1**

(12) **EUROPÄISCHE PATENTSCHRIFT**

(45) Veröffentlichungstag und Bekanntmachung des Hinweises auf die Patenterteilung:
**27.06.2007  Patentblatt 2007/26**

(21) Anmeldenummer: **01999944.0**

(22) Anmeldetag: **22.11.2001**

(51) Int Cl.:
*G11C 11/15* $^{(2006.01)}$

(86) Internationale Anmeldenummer:
**PCT/DE2001/004400**

(87) Internationale Veröffentlichungsnummer:
**WO 2002/047089 (13.06.2002 Gazette 2002/24)**

(54) **MAGNETORESISTIVER SPEICHER UND VERFAHREN ZU SEINEM AUSLESEN**

MAGNETORESISTIVE MEMORY AND METHOD FOR READING OUT FROM THE SAME

MEMOIRE MAGNETORESISTIVE ET PROCEDE D'EXTRACTION APPROPRIE

(84) Benannte Vertragsstaaten:
**DE FR GB IT**

(30) Priorität: **05.12.2000  DE 10060432**

(43) Veröffentlichungstag der Anmeldung:
**03.09.2003  Patentblatt 2003/36**

(73) Patentinhaber: **Infineon Technologies AG**
**81669 München (DE)**

(72) Erfinder:
 • **THEWES, Roland**
   **82194 Gröbenzell (DE)**
 • **WEBER, Werner**
   **80637 München (DE)**
 • **VAN DEN BERG, Hugo**
   **NL-8355 Diethoom (NL)**

(74) Vertreter: **Kottmann, Heinz Dieter**
**Patentanwälte**
**MÜLLER & HOFFMANN,**
**Innere Wiener Strasse 17**
**81667 München (DE)**

(56) Entgegenhaltungen:
**EP-A- 0 595 266     US-A- 6 021 065**
**US-A- 6 128 228     US-B1- 6 205 073**

EP 1 340 230 B1

## Beschreibung

Die Erfindung betrifft einen magnetoresistiven Speicher und ein Verfahren zum Auslesen von Speicherzellen in einem solchen magnetoresistiven Speicher.

Magnetoresistive Speicher stellen eine Alternative zu herkömmlichen DRAM- und SRAM-Speichern sowie zu nichtflüchtigen Speichern, beispielsweise Flash oder EEPROM, dar. Sie bestehen aus einer Anordnung von Speicherzellen, an die Bitleitungen und Wortleitungen herangeführt sind. Die einzelne Speicherzelle eines magnetoresistiven Speichers besteht aus zwei magnetischen Elementen, welche durch ein Dielektrikum voneinander getrennt sind. Eines der magnetischen Elemente ist hartmagnetisch und somit in seiner Magnetflußrichtung vorgegeben, das andere ist weichmagnetisch und kann durch Anlegen geeigneter Schaltströme an die Bit- und Wortleitungen in seiner Orientierung umgekehrt werden. Das zwischen den beiden magnetischen Elementen angeordnete Dielektrikum ist ein sogenanntes Tunneldielektrikum, beispielsweise eine als Tunneldielektrikum geeignete Schicht von 2 nm Dicke. Das Tunneldielektrikum weist als Besonderheit einen elektrischen Widerstand auf, welcher abhängig ist von dem ihn umgebenden Magnetfeld. Wenn beide magnetischen Elemente auf beiden Seiten des Tunneldielektrikums gleichsinnig orientiert sind, weist das Dielektrikum einen anderen Widerstandswert auf, als wenn die Magnetflußrichtungen der beiden magnetischen Elemente zueinander invertiert sind. Durch Anlegen einer geeigneten Spannung an die Bitleitungen und Wortleitungen kann der jeweils im Tunneldielektrikum aktuelle Wert des Widerstandes bestimmt werden und somit auf die Orientierung der magnetischen Elemente geschlossen werden. Insgesamt ergibt sich daher ein binär arbeitendes Zustandssystem, das somit zur Speicherung digitaler Informationen geeignet ist. Eine spezielle Bauart von magnetoresistiven Speicherzellen beinhaltet neben dem funktionsinhärenten Widerstand eine Diodenfunktion.

Bei einer solchen Anordnung von Speicherzellen bietet es sich beispielsweise an, jeweils über und unter den eigentlichen Speicherzellen parallel laufende Bit- beziehungsweise Wortleitungen vorzusehen, die zueinander wiederum rechtwinklig angeordnet sind. Am Rand der Speicherzellenanordnung können die Bitleitungen und Wortleitungen dann in zusätzliche Schaltungen zum Schreiben und Lesen überführt werden.

Arrays von MRAM-Massenspeichern wurden bislang noch nicht als Produkte vorgestellt. Es sind lediglich kleinere Anordnungen (Arrays) verfügbar, die zumeist auf dem Prinzip "Current In-Plane" beruhen, während dem Prinzip "Current Perpendicular to Plane" für Massenspeicheranwendungen größere Chancen gegeben werden. Magnetoresisitve Speicher bieten bestimmte prinzipielle Vorteile, wie einfache Fertigung, nichtflüchtige Datenerhaltung und gute Shrinkeignung. Ihre Eignung als Massenspeicher hängt in hohem Maße davon ab, ob ausreichend große Speicherzellenblöcke verwirklicht werden können. Anordnungen (Arrays) von konkurrenzfähigen Massenspeichern müssen folgende Anforderungen gleichzeitig erfüllen:

- Das Array muss eine Größe von (einigen hundert) x (einigen hundert) Speicherzellen erlauben.
- Das Lesesignal muss eine bestimmte Mindestgröße haben, um eine hinreichend sichere Bewertung zu ermöglichen. Beispiele von Halbleiter-Speichern:

  - DRAMs benötigen ca. 100-150 mV. Sie führen Spannungsbewertung am Arrayrand durch mit Leseverstärkern, die im Pitch sitzen.

  - Flash-Speicher (embedded) benötigen ca. 10 $\mu$A. Sie führen Strombewertung mit Leseverstärkern in der Peripherie durch.

  - SRAMs arbeiten mit On-Strömen von ca. 150 $\mu$A und vernachlässigbaren Off-Strömen. Sie erreichen Arrayzugriffszeiten von 600 ps - 1.2 ns.

  Genaue Werte können für MRAM nicht a priori angegeben werden, sondern es muß fallweise geprüft werden, ob das Lesesignal für eine zuverlässige störunempfindliche Bewertung ausreicht.

Der Energieverbrauch beim Lesen sollte mit dem DRAM vergleichbar oder niedriger sein (je nach Architektur 1 pJ -1 nJ). Diese Forderungen müssen auch an eine Massenspeicheranwendung von MRAMs gestellt werden.

Im Stand der Technik sind verschiedene Vorschläge unterbreitet worden, um magnetoresistive Speicherzellenanordnungen zu konfigurieren. Die dort vorgestellten Schaltungen neigen jedoch in der Anwendung zu Stabilitätsproblemen. Es ist daher die Aufgabe der vorliegenden Erfindung, eine geeignete Architektur zum zuverlässigen Beschreiben, Lesen und Löschen von magnetoresistiven Speicherzellen in Anordnungen von solchen Speicherzellen, das heißt magnetoresistiven Speichern, bereitzustellen.

Erfindungsgemäß wird diese Aufgabe gelöst durch die Bereitstellung eines magnetoresistiven Speichers gemäß dem unabhängigen Patentanspruch 1 und eines Verfahrens zum Auslesen von Speicherzellen gemäß dem unabhängigen Patentanspruch 20. Weitere vorteilhafte Ausgestaltungen und Aspekte und Details der Erfindung ergeben sich aus den abhängigen Patentansprüchen, der Beschreibung und den beigefügten Zeichnungen.

Der vorliegenden Erfindung liegt das Prinzip zugrunde, die auszulesende Speicherzelle an beiden Polen mit festen Spannungen unabhängig von einem Strom durch die Zelle zu betreiben, was dadurch geschieht, daß an den einen Pol der Zelle eine Festspannungsquelle angeschlossen wird und an den anderen Pol der Zelle eine Regelschaltung angeschlossen wird, welche das Potential an diesem Pol unabhängig vom Zellenstrom konstant hält. Der Strom ist damit abhängig vom Zellenzustand, der nunmehr durch Messen des Stroms oder einer davon abhängigen Größe bestimmt werden kann.

Die Erfindung ist daher zunächst gerichtet auf einen magnetoresistiven Speicher mit einer Anordnung von in einer Mehrzahl von Reihen und/oder einer Mehrzahl von Spalten angeordneten magnetoresistiven Speicherzellen mit einem Widerstand und einer Diodenfunktion; einer Bitleitung für jede der Spalten, die mit ersten Polen der zu der Spalte gehörenden Speicherzellen verbunden ist; einer Wortleitung für jede der Reihen, die mit zweiten Polen der zu der Reihe gehörenden Speicherzellen verbunden ist; einer ersten Lesespannungsquelle mit einer ersten Spannung, die mit ersten Enden der Wortleitungen durch Schaltelemente einzeln verbindbar ist.

Der erfindungsgemäße Speicher ist gekennzeichnet durch eine Regelschaltung mit einem ersten Pol, welcher über einen Leseverteiler durch Schaltelemente mit ersten Enden der Bitleitungen einzeln verbindbar ist; einem zweiten Pol, aus welchem Strom in einen Bewerter einspeisbar ist oder eingespeist wird; und einem dritten Pol, welcher mit einer Referenzspannungsquelle verbunden ist; eine dritte Spannungsquelle mit einer Spannung, die in etwa gleich der Spannung der ersten Lesespannungsquelle ist und welche über Schaltelemente mit zweiten Enden der Bitleitungen einzeln verbindbar ist; und eine vierte Spannungsquelle, welche über Schaltelemente mit zweiten Enden der Wortleitungen einzeln verbindbar ist. Die Erfindung ist weiter dadurch gekennzeichnet, daß die Spannung der Referenzspannungsquelle und die Regelschaltung so ausgelegt sind, daß am ersten Pol eine Spannung anliegt, die in etwa der Spannung der vierten Spannungsquelle entspricht; und der durch den zweiten Pol der Regelschaltung fliessende Strom in etwa gleich dem durch den ersten Pol der Regelschaltung fliessenden Strom ist und dieser Strom unabhängig von der am zweiten Pol der Regelschaltung anliegenden Spannung ist.

Unter "im wesentlichen gleich" ist im Sinne der vorliegenden Erfindung zu verstehen, daß der Strom an den beiden Polen sich höchstens in einem Masse unterscheidet, daß die Messung des Stroms durch den Bewerter zuverlässig Aufschluß über den Zustand der Zelle geben kann (sei dies mittels einer oder mehrerer Messungen erreichbar). Die in einer Anordnung organisierte Mehrzahl von Speicherzellen verfügt über Reihen und Spalten. Da zur Durchführung des erfindungsgemäßen Verfahrens Spannungen an solche Wort- und Bitleitungen angelegt werden, die nicht mit der auszulesenden Speicherzelle verbunden sind, folgt, daß zumindest in einer der beiden angegebenen Dimensionen, also bei Reihen oder bei Spalten, mehr als eine Leitung vorhanden sein muß. Die Mindestzahl von Speicherzellen, bei denen die Erfindung sinnvoll einsetzbar ist, beträgt somit zwei. Wünschenswert ist selbstverständlich eine höhere Zahl von Speicherzellen und eine solche wird in aller Regel in der Praxis auch vorhanden sein.

Der durch die auszulesende Zelle fließende Strom kann im wesentlichen beschrieben werden als:

$$I = U_1 - U^* - U_D \; / \; R_z;$$

wobei $U_1$ die Spannung der ersten Lesespannungsquelle ist, $U^*$ die Spannung am ersten Pol der Regelschaltung, $U_D$ der Spannungsabfall an der Diode und $R_Z$ der von der Magnetisierung abhängige Zellenwiderstand. Dieser Strom entspricht dem Strom, der von dem zweiten Pol der Regelschaltung in den Bewerter bzw. in die Bewerterleitung fliest. Dieser Stromfluß kann durch den Bewerter bestimmt werden und daraus kann auf den Zustand der zu bewertenden Zelle geschlossen werden.

Der Strom kann beispielsweise mit Hilfe eines Abschlußwiderstandes R in eine zu bewertende Spannung umgesetzt werden,
wobei:

$$U_B = I \; * \; R;$$

und $U_B$ die Spannung am Abschlußwiderstand R an der Bewerterleitung ist.

Bei diesen Betrachtungen sind Innenwiderstände der verwendeten Leiter nicht berücksichtigt worden.

Dementsprechend kann der Bewerter mit einem Eingang über eine Bewerterleitung mit dem zweiten Pol der Regelschaltung verbunden oder verbindbar sein; wobei von der Bewerterleitung ein erster linearer oder nicht linearer Abschlußwiderstand abzweigen kann.

Der Bewerter kann also ein Spannungsbewerter sein und die von ihm bewertete Spannung abhängig, beispielsweise proportional dem durch den zweiten Pol der Regelschaltung fliessenden Strom sein.

Der Bewerter-Teil der bevorzugten, erfindungsgemäßen Schaltung kann in dieser Ausführungsform also mithin als ein Strom/Spannungswandler betrachtet werden.

Zur Realisierung der Regelschaltung stehen dem Fachmann verschiedene Möglichkeiten zur Verfügung, durch welche das erfindungsgemäße, oben beschriebene Verhalten dieser Regelschaltung erreicht werden kann. So ist es möglich, die Regelschaltung mittels eines Operationsverstärkers und eines Transistors aufzubauen. Hierbei kann die Regelschaltung einen Operationsverstärker mit zwei Eingängen aufweisen, dessen nicht invertierender Eingang als dritter Pol der Regelschaltung mit der Referenzspannungsquelle verbunden ist und dessen invertierender Eingang als erster Pol der Regelschaltung mit den ersten Enden der Bitleitungen einzeln verbindbar ist, wobei der Operationsverstärker einen Ausgang aufweist, der mit dem Gate-Bereich eines Transistors mit zwei Source/Drain-Bereichen verbunden ist, dessen einer Source/Drain-Bereich mit dem invertierten Eingang des Operationsverstärkers verbunden ist und dessen anderer Source/Drain-Bereich als zweiter Pol der Regelschaltung mit dem Bewerter verbunden ist. Hierbei ist die am ersten Pol der Regelschaltung anliegende Spannung gleich der am dritten Pol angelegten Spannung.

In der Regel ist dabei der Source-Bereich des verwendeten Transistors mit dem ersten Pol der Regelschaltung verbunden. Der Operationsverstärker in einer solchen Regelschaltung gewährleistet bauartbedingt, daß die Spannung am ersten Pol stets derjenigen am dritten Pol entspricht, so daß die Grundbedingung der Regelschaltung der vorliegenden Erfindung durch einen Operationsverstärker in günstiger Weise gewährleistet werden kann.

Um eine Vereinfachung der erfindungsgemäßen Speicherschaltung zu erreichen, kann es weiterhin bevorzugt sein, die erste Spannungsquelle mit der dritten Spannungsquelle identisch zu machen, d. h. zusammenzufassen; sowie die Referenzspannungsquelle und die vierte Spannungsquelle zusammenzufassen, wenn die Regelschaltung mit Hilfe eines Operationsverstärkers realisiert wird. Auf diese Weise läßt sich die Übereinstimmung der Spannungen besonders gut erreichen.

Alternativ zu dieser Ausführungsform kann die Entkopplung von Spannung an den Zellen und Spannung an der Bewerterschaltung bzw. die Konstanz der Spannung an den Zellen unabhängig vom Zellstrom durch eine Regelschaltung ereicht werden, die einen bipolaren Transistor aufweist, dessen Basis als dritter Pol der Regelschaltung mit der Referenzspannungsquelle verbunden ist, dessen Emitter als erster Pol der Regelschaltung mit den ersten Enden der Bitleitungen einzeln verbindbar ist und dessen Kollektor als zweiter Pol der Regelschaltung mit der Bewerterleitung verbunden ist. Auch durch diese Maßnahmen kann die Spannung innerhalb des Zellenbereichs auf einem vorgegebenen Wert gehalten werden, der durch die Referenzspannungsquelle definiert ist. In diesem Falle ist die Spannung am Emitter jedoch um den Betrag der Basis-Emitter-Diodenansprechspannung gegenüber der Referenzspannung versetzt, d.h. anders als im Falle der Regelschaltung mit Operationsverstärker und MOS-Transistor müssen hier die Werte der vierten Spannungsquelle und der Referenzspannungsquelle nicht näherungsweise gleich gewählt werden, sondern es muß der Wert der Referenzspannungsquelle derart angepasst werden, daß sich am Emitter in etwa der Wert der vierten Spannungsquelle einstellt.

Unter einem Abschlußwiderstand ist ein Widerstand zu verstehen, in dessen einen Pol der zu bewertende Strom eingespeist wird und dessen anderer Pol mit einer weiteren Referenzspannung verbunden ist. In der Regel handelt es sich bei dieser Referenzspannung um GND, es ist jedoch auch ein anderes Potential möglich, beispielsweise auch eines, welches höher ist als dasjenige der Lesespannungsquelle. In diesem Fall muß die Schaltung entsprechend angepasst werden, was dem Fachmann als Maßnahme geläufig ist.

Unter einer in etwa gleichen Spannung im Sinne der vorliegenden Erfindung ist hierbei zu verstehen, daß die Abweichung zwischen den Spannungen, d. h. zwischen erster und dritter bzw. Referenz- und vierter Spannung, kleiner sein muß als die Ansprechspannung der Diode, um einen unerwünschten Stromschluß durch nicht auszulesende Speicherzellen zu verhindern. Diese Anforderung an die Genauigkeit der Übereinstimmung der Werte der Spannung muß ferner auf das gesamte Zellenfeld ausgedehnt werden, bei dessen einzelnen Zellen es ebenfalls zu kleinen Leckströmen kommen kann, die sich über das gesamte Feld aufaddieren. Die sich hieraus ergebende Bedingung an die Übereinstimmung von erster und dritter bzw. vierter und Referenz-Spannung ist abhängig von der gesamten Größe und Konfiguration des Zellenfeldes, stellt jedoch im Allgemeinen ein schärferes Kriterium als das zuvor genannte dar. Es ist jedoch durch geeignete schaltungstechnische Maßnahmen (z.B. U1 und U3 bzw. U4 und U5 (nur sinnvoll bei entsprechenden Ausführungsformen, z.B. mit einem Operationsverstärker) pysikalisch zusammenfassen, d.h. nicht getrennt realisieren) gut erfüllbar.

Hierbei kann die Referenzspannung kleiner sein als die erste Spannung. Es kann jedoch auch die erste Spannung kleiner sein als die Referenzspannung. In diesem Fall sind am Rest der erfindungsgemäßen Schaltung entsprechende Modifikationen vorzunehmen. So kann es beispielsweise notwendig werden, sonst an GND-liegende Pole mit einer Betriebsspannung zu versehen, Transistoren zu invertieren, so einen pMOS-Transistor gegen einen nMOS-Transistor auszutauschen, und die Dioden im Zellenfeld in ihrer Durchlassrichtung umzukehren.

Die Spannungsdifferenz zwischen erster Spannung und Spannung am ersten Pol der Regelschaltung sollte so ausgelegt sein, daß sie hinreichend ist, um bei gegebenem Widerstand in der auszulesenden Speicherzelle und Ansprechspannung der Diodenfunktion einen hinreichenden Stromfluß durch die auszulesende Speicherzelle zu erzielen.

Die Dioden der magnetoresistiven Speicherzellen sind vorzugsweise so orientiert, daß beim Anlegen der Spannungen ein Strom durch die auszulesende Speicherzelle fließen kann. In Abhängigkeit von der Wahl der Spannungen bedeutet dies, daß sich gegebenenfalls die Orientierung der Dioden umkehren kann.

Um das zeitliche Ansprechverhalten der Schaltung zu verbessern, kann es weiterhin bevorzugt sein, daß der Leseverteiler zusätzlich mit einer Vorladequelle (einer zweiten Spannungsquelle, U2) verbunden bzw. verbindbar ist. Die Spannung der Vorladequelle ist vorzugsweise im wesentlichen gleich der am ersten Pol der Regelschaltung anliegenden Spannung bzw. der Spannung der vierten Spannungsquelle, welche sich über die Regelschaltung in Abhängigkeit vom Wert der Spannung U5 einstellt (d.h. bei OP-Schaltung U2=U5). Diese Ausführungsform erweist sich als günstig in Kombination mit unten skizzierten Ausführungsformen der Erfindung, bei der Kapazitäten innerhalb des Zellenfeldes auf- bzw. umgeladen werden müssen, nämlich insbesondere die Parasitärkapazität der ausgewählten Bitleitung. Auch hierbei können Vorladequelle und vierte Spannungsquelle zu einer einzigen Spannnungsquelle zusammengefasst werden.

Im Prinzip wäre es denkbar, auf die Vorladung durch die Vorladequelle U2 zu verzichten. Dann müßte die Auf- bzw. Umladung der Kapazitäten der Bitleitungen innerhalb des Zellenfeldes durch den Zellwiderstand geschehen. Die dazu benötigte Zeit liegt allerdings im Mikrosekundenbereich und ist damit für viele Anwendungen zu lang.

Der magnetoresistive Speicher kann vorzugsweise so ausgestaltet sein, daß die Bewerterleitung zwei Bewerterpfade aufweist, die durch Schaltelemente mit dem zweiten Pol der Regelschaltung einzeln verbindbar sind; wobei von den Bewerterpfaden je ein Abschlußwiderstand abzweigt; und wobei jeder der beiden Bewerterpfade durch ein Schaltelement mit einem Eingang des Spannungsbewerters und einer dazu parallelen Kapazität verbindbar ist.

Durch diese bevorzugte Anordnung von Elementen ergeben sich effektiv zwei Bewerterpfade anstelle des oben skizzierten einen Bewerterpfads. Auf diese Weise ist es möglich, zwei voneinander unabhängige Bewertungen des an der auszulesenden Speicherzelle vorhandenen Widerstands durchzuführen.

Hierbei können die beiden Abschlußwiderstände einen identischen Widerstandswert aufweisen oder sich in ihren Widerstandswerten unterscheiden. Die beiden vorhandenen Kapazitäten dienen dazu, die aufgetretenen Spannungen während und nach der Messung zwischenzuspeichern, so daß in einem entsprechenden Spannungsbewerter mit zwei Eingängen ein Vergleich der beiden Spannungen durchgeführt werden kann. Die Anordnung von zwei voneinander unabhängigen Bewerterpfaden ermöglicht beispielsweise auch das zweifache Bewerten einer Speicherzelle und eine Mittelwertbildung, aus der sich mit größerer Genauigkeit der Widerstandswert und damit der binäre Sinngehalt der Speicherzelle ermitteln läßt.

Es ist jedoch auch möglich, zwischen den beiden Bewertungen einen Umschaltversuch durchzuführen, um aus einer sich gegebenenfalls ergebenden Änderung des Widerstandswerts der auszulesenden Speicherzelle auf den vormaligen binären Zustand der Speicherzelle rückschließen zu können. Um einen solchen Umschaltversuch vornehmen zu können, weist der erfindungsgemäße magnetoresistive Speicher vorzugsweise weiterhin auf: eine erste Schreibstromquelle, die mit den ersten Enden der Wortleitungen durch Schaltelemente einzeln verbindbar ist, und eine zweite Schreibstromquelle, die mit den ersten Enden der Bitleitungen durch Schaltelemente einzeln verbindbar ist. Durch die über die Schreibstromquellen bereitgestellten Ströme durch die jeweils ausgewählte Wort- und Bitleitung in Verbindung mit dem Anlegen von durch die dritten und vierten Spannungsquellen bereitgestellten Spannungen an die auszulesende Speicherzelle kann ein solcher Umschaltversuch in eine bestimmten Richtung durchgeführt werden.

Wie beschrieben, müssen Spannungsquellen und Schreibstromquellen einzeln mit den jeweils verwendeten Enden der Wort-und Bitleitungen verbindbar sein. Zu diesem Zweck werden Verteiler bereitgestellt, welche die ein- und auslaufenden Signale und Spannungen zu den verschiedenen Wort- und Bitleitungen bringen. Bei den Verteilern handelt es sich somit um verzweigte Leiterbahnsysteme, an deren Enden günstigerweise die Schaltelemente zur Verbindung mit den Wort- und Bitleitungen angeordnet sind. Demnach kann die Verbindung der Bitleitungen mit der Regelschaltung durch einen Leseverteiler mit einem Schaltelement für jede der Bitleitungen erfolgen. Die Verbindung der Bitleitungen mit der zweiten Schreibstromquelle kann ebenfalls durch den Leseverteiler erfolgen, wobei die zweite Schreibstromquelle und die Regelschaltung durch Schaltelemente mit dem Leseverteiler verbindbar sind.

Die Verbindung der Bitleitung mit der Vorladequelle kann ebenfalls durch den Leseverteiler erfolgen, wobei Vorladequelle und Regelschaltung durch Schaltelemente mit dem Leseverteiler verbindbar sind.

Die Schaltelemente zur Verbindung von zweiter Schreibstromquelle, Regelschaltung und Vorladequelle mit dem Bewerterverteiler dienen dazu, die Kontakte alternativ herstellen zu können, da es z.B. nicht sinnvoll ist, eine direkte elektrische Verbindung zwischen Regelschaltung und Schreibstromquelle zuzulassen.

Die Verbindung der dritten und vierten Spannungsquellen mit den Bit- und Wortleitungen kann durch Spannungsverteiler mit einem Schaltelement für jede Bit- und Wortleitung erfolgen.

Ebenso kann die Verbindung der Lesespannungsquelle mit den Wortleitungen durch einen Lesespannungsverteiler, ebenfalls mit einem Schaltelement für jede Wortleitung erfolgen.

Schließlich kann die Verbindung der ersten Schreibstromquelle mit den Wortleitungen ebenfalls durch den Lesespannungsverteiler erfolgen, wobei die erste Schreibstromquelle und die erste Lesespannungsquelle, in ähnlicher Weise wie bereits die zweite Schreibstromquelle und die Regelschaltung, durch Schaltelemente mit dem Lesespannungsverteiler verbindbar sein.

Vorzugsweise werden die oben erwähnten Schaltelemente zumindest teilweise, vorzugsweise jedoch insgesamt als Transistoren ausgebildet sein.

Die zum Einsatz kommenden magnetoresistiven Speicherzellen sind vorzugsweise sogenannte Vertikalstromspeicherzellen (Current Perpendicular to Plane). Bei diesen sind die Elemente der Speicherzellen, nämlich Bitleitung, erstes magnetisches Element, Tunneldielektrikum, zweites magnetisches Element und Wortleitung vertikal übereinander, bezogen auf eine Oberfläche in einem integrierten Schaltkreis respektive seinen Siliziumstrukturen, angeordnet. Bei der Bewertung fließt der Strom somit von oben nach unten oder von unten nach oben.

Die Erfindung ist weiterhin auf ein Verfahren gerichtet. Bezüglich des Verfahrens gilt alles oben hinsichtlich der Vorrichtung Gesagte, wobei darauf vollinhaltlich Bezug genommen wird.

Die Erfindung ist gerichtet auf ein Verfahren zum Auslesen von Speicherzellen in einem magnetoresistiven Speicher mit einer Anordnung von in einer Mehrzahl von Reihen und/oder einer Mehrzahl von Spalten angeordneten magnetoresistiven Speicherzellen; einer Bitleitung für jede der Spalten, die mit ersten Polen der zu der Spalte gehörenden Speicherzellen verbunden ist; einer Wortleitung für jede der Reihen, die mit zweiten Polen der zu der Reihe gehörenden Speicherzellen verbunden ist; und einer Referenzspannungsquelle mit einer Referenzspannung die mit dem dritten Pol einer Regelschaltung verbunden ist, deren erster Pol mit dem ersten Pol der auszulesenden Speicherzelle verbunden ist, wobei die Regelschaltung eine am ersten Pol anliegende Spannung erzeugt, welche in einer definierten Funktion zu der Referenzspannung am dritten Pol der Regelschaltung (1) steht (beispielsweise gleich der Referenzspannung ist); wobei das Verfahren folgende Schritte aufweist:

A: Anlegen einer ersten Lesespannungsquelle mit einer ersten Spannung an den zweiten Pol einer auszulesenden Speicherzelle;

B: Anlegen einer dritten Spannungsquelle mit einer Spannung, die in etwa gleich der ersten Spannung ist, an diejenigen Bitleitungen, welche nicht mit der auszulesenden Speicherzelle verbunden sind;

C: Anlegen einer vierten Spannungsquelle mit einer Spannung, die in etwa gleich der am ersten Pol der Regelschaltung anliegenden Spannung ist, an diejenigen Wortleitungen, welche nicht mit der auszulesenden Speicherzelle verbunden sind;

D: Bewerten des durch einen zweiten Pol der Regelschaltung und die auszulesende Speicherzelle (3a) fließenden Stroms oder einer davon abgeleiteten Größe durch einen Bewerter, in welchen aus dem zweiten Pol der Regelschaltung (1) Strom eingespeist wird.

Eine mögliche, abgeleitete Größe kann beispielsweise die Spannung sein. So kann die abgeleitete Größe eine über einen ersten Abschlußwiderstand abfallende Spannung sein und mit einem zum ersten Abschlußwiderstand parallelen Spannungsbewerter bewertet werden, wobei die Spannung proportional dem Strom ist, welcher durch die auszulesende Speicherzelle fließt.

Während der Spannungsbewerter eine Messung der anliegenden Spannung durchführt, um über den Stromfluß auf den Widerstandswert der auszulesenden Speicherzelle rückschließen zu können, liegen an den nicht angesprochenen Wort- und Bitleitungen Spannungen an, welche in Verbindung mit den Dioden der Speicherzellen verhindern, daß ungewollte Stöme auftreten. Insgesamt läßt sich durch diese Anordnung die Stabilität des Auslesevorgangs und dessen Genauigkeit wesentlich erhöhen und die Verlustleistung des gesamten Systems erheblich reduzieren.

Die sukzessive Schilderung der erfindungsgemäßen Verfahrensschritte beinhaltet keine zeitliche Abfolge. Während die Schritte nacheinander durchgeführt werden können, müssen doch für eine zuverlässige Bewertung durch den Spannungsbewerter alle durch die Schritte A, B, und C einzustellenden Bedingungen erst gewährleistet sein, bevor eine zuverlässige Messung möglich ist. Es ist daher aus Praktikabilitäts- sowie auch aus Geschwindigkeitsgründen bevorzugt, daß die Schritte A bis C im wesentlichen gleichzeitig ausgeführt werden. Auch Schritt D kann im wesentlichen gleichzeitig oder möglichst rasch nach den anderen Schritten ausgeführt werden.

Das erfindungsgemäße Verfahren kann weiterhin die Erzeugung einer Vorladung auf den mit den Speicherzellen verbundenen Leitungen beinhalten, da diese größere Parasitärkapazitäten aufweisen. Diese Maßnahme kann das Ansprechverhalten des Speichers verbessern und damit insbesondere die Zugriffszeit verringern und durch folgende zusätzliche Schritte gekennzeichnet sein:

vor Schritt D, C, oder B:

A2: Anlegen einer Vorladequelle, deren Spannung im wesentlichen gleich der am ersten Pol der Regelschaltung anliegenden Spannung ist, an die mit dem ersten Pol der auszulesenden Speicherzelle verbundene Bitleitung; und

nach Schritt A2 und vor Schritt D, C, oder B:

A3: Trennen der Vorladequelle von der mit dem ersten Pol der auszulesenden Speicherzelle verbundenen Bitleitung.

Wie bereits oben geschildert, läßt sich das erfindungsgemäße Verfahren weiter verfeinern, um die Genauigkeit der Wertebestimmung der auszulesenden Speicherzellen zu verbessern. So ist es möglich, zwei voneinander unabhängige Lesevorgänge vorzunehmen, bei denen die jeweils entstehenden Spannungen in zwei, mit Eingängen des Spannungsbewerters parallel geschalteten Kapazitäten zwischengespeichert werden. Die so zwischengespeicherten Spannungswerte können dann im Spannungsbewerter abschließend zusammen bewertet werden. Es ist jedoch auch möglich, das Verfahren dahingehend zu verbessern, daß die zwei Lesevorgänge nacheinander durchgeführt werden und ein Umschaltversuch dazwischen durchgeführt wird. Dies hat den Vorteil, daß die Messung der Spannungen nicht so genau erfolgen muß, da mehr auf möglicherweise auftretende Unterschiede der sich ergebenden Spannungen vor und nach dem Umschaltversuch abzustellen ist. Das Verfahren weist somit einen ersten Lesevorgang auf, gefolgt von einem Umschaltversuch, der wiederum von einem zweiten Lesevorgang des Spannungswertes gefolgt ist. Eine vorzugsweise Ausführungsform dieses mehrschrittigen Verfahrens beinhaltet folgende weitere Schritte:

E: Speichern der über den ersten Abschlußwiderstand abfallenden Spannung in einer ersten Kapazität, die mit dem Spannungsbewerter parallel geschaltet ist;

F: Trennen der ersten Kapazität vom ersten Abschlußwiderstand und von dem zweiten Pol der Regelschaltung;

G: Trennen der ersten Lesespannungsquelle von der auszulesenden Speicherzelle;

H: Trennen der Regelschaltung von der auszulesenden Speicherzelle;

I: Anlegen der an der vierten Spannungsquelle anliegenden Spannung an alle Wortleitungen;

J: Anlegen der an der dritten Spannungsquelle anliegenden Spannung an alle Bitleitungen;

K: Anlegen einer ersten Stromquelle an die mit dem zweiten Pol der auszulesenden Speicherzelle verbundene Wortleitung;

L: Anlegen einer zweiten Stromquelle an die mit dem zweiten Pol der auszulesenden Speicherzelle verbundene Bitleitung;

M: Trennen der ersten Stromquelle von der mit dem zweiten Pol der auszulesenden Speicherzelle verbundenen Wortleitung;

N: Trennen der zweiten Stromquelle von der mit dem ersten Pol der auszulesenden Speicherzelle verbundenen Bitleitung;

O: Anlegen der ersten Lesespannungsquelle an den zweiten Pol der auszulesenden Speicherzelle;

P: Verbinden des ersten Pols der Regelschaltung mit der auszulesenden Speicherzelle;

Q: Anlegen der dritten Spannungsquelle an diejenigen Bitleitungen, welche nicht mit der auszulesenden Speicherzelle verbunden sind;

R: Anlegen der vierten Spannungsquelle an diejenigen Wortleitungen, welche nicht mit der auszulesenden Speicherzelle verbunden sind;

S: Verbinden des zweiten Pols der Regelschaltung mit einem zweiten Abschlußwiderstand; einer zum zweiten Abschlußwiderstand parallelen zweiten Kapazität und einem dazu parallelen zweiten Eingang des Spannungsbewerters;

T: Speichern der über den zweiten Abschlußwiderstand abfallenden Spannung in der zweiten Kapazität;

U: Trennen der zweiten Kapazität vom zweiten Abschlußwiderstand und von dem zweiten Pol der Regelschaltung; und

V: Vergleichen der in der ersten und der zweiten Kapazität gespeicherten Spannung im Spannungsbewerter.

Es soll hier angemerkt werden, daß die vorstehend geschilderte Ausführungsform des erfindungsgemäßen Verfahrens im Hinblick auf die Verwendung eines Spannungsbewerters und der Erfassung der vom Strom abgeleiteten Größe Spannung beschrieben wurde, da die hier notwendige Zwischenspeicherung der beiden Messungen in einfacher Weise erfolgen kann. Schritt U ist überdies nur notwendig, falls zwischen Speicherung und Bewertung weitere Vorgänge im Zellenfeld bzw. in der gesamten Schaltung stattfinden könnten, welche zu einer Entleerung des zweiten Kondensators führen würden. Die oben angegebenen Schritte des erfindungsgemäßen Verfahrens führen zu einer klaren Verbesserung der Bewertungsqualität. Auch hier gilt, daß trotz der Aneinanderreihung der verschiedenen Schritte nicht alle Schritte nacheinander ablaufen müssen. Vielmehr ist es möglich, verschiedene Schritte auch gleichzeitig oder im wesentlichen gleichzeitig durchzuführen. So ist es bevorzugt, daß die Schritte A bis D und E im wesentlichen gleichzeitig ausgeführt werden. Ebenso wird es bevorzugt, daß die Schritte F, G, und H im wesentlichen gleichzeitig ausgeführt werden, wobei diese als Schritte, die der Überleitung zum Schreibversuch dienen, nach dem ersten Lesevorgang und damit nach den Schritten A bis E durchgeführt werden sollten. Auch wird es bevorzugt, daß die Schritte I bis L im wesentlichen gleichzeitig ausgeführt werden, wobei diese nach den Trennungsschritten F, G, und H erfolgen sollten. Weiterhin können die Schritte M und N im wesentlichen gleichzeitig ausgeführt werden, wobei auch diese wiederum nach den Schritten A bis L erfolgen sollten. Schließlich ist es auch möglich, die Schritte O bis T im wesentlichen gleichzeitig auszuführen. Diese beinhalten den nachgeschalteten, zweiten Lesevorgang.

Das erfindungsgemäße Verfahren kann weiterhin dadurch gekennzeichnet sein, daß die Referenzspannung kleiner ist als die erste Spannung, wobei auch der umgekehrte Fall erwogen werden kann, wie oben bezüglich der Offenbarung des erfindungsgemäßen Speichers bereits ausgeführt. Auch hier sollte gelten, daß die Spannungsdifferenz hinreichend ist, um bei gegebenem Widerstand in der auszulesenden Speicherzelle und Ansprechspannung der Diodenfunktion einen hinreichenden Stromfluß durch die auszulesende Speicherzelle zu erzielen.

Im folgenden soll die Erfindung an Hand eines Ausführungsbeispiels näher erläutert werden, wobei auf die beigefügten Zeichnungen Bezug genommen wird, in denen folgendes dargestellt ist:

Figur 1 zeigt eine Ausführungsform eines erfindungsgemäßen magnetoresistiven Speichers während des Lesevorgangs; und

Figur 2 zeigt eine weitere Ausführungsform des erfindungsgemäßen magnetoresistiven Speichers, wobei Spannungsquellen zusammengefasst sind.

Wie oben beschrieben, ist es möglich, die Erfindung unter Verwendung eines einfachen Bewerters mit einem Eingang und eines einfachen Bewertungsverfahrens auszuführen. Die im folgenden näher beschriebene doppelte Lesemethode erlaubt eine zuverlässigere Bewertung trotz der erwarteten großen lokalen Zellwiderstandsvariationen. In einzelnen sind dies folgende Schritte:

1. Auslesen des Zell-Zustandes und Speicherung der Information,
2. anschließend Schaltversuch in eine bestimmte Richtung,
3. weiteres Auslesen des Zell-Zustandes und Speicherung der Information,
4. Vergleich der Ergebnisse und Bewertung.

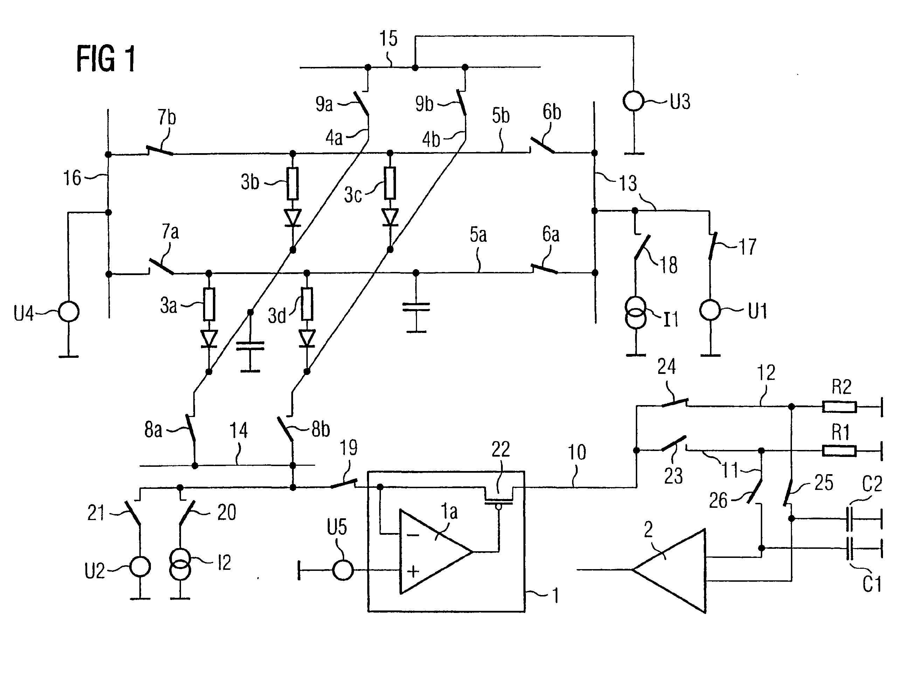

Eine Ausführungsform einer Schaltung des erfindungsgemäßen magnetoresistiven Speichers ist in Figur 1 gezeigt. Vorgesehen wird eine Matrix, bestehend aus m Wortleitungen 5a, 5b und n Bitleitungen 4a, 4b, bei der die selektierte Wortleitung 5a mittels einer ersten Lesepannungsquelle U1 über einen Lesespannungsverteiler 13 und ein Schaltelement 6a auf ein vorgegebenes Potential gelegt wird, beispielsweise 2 Volt. Die zu der auszulesenden Speicherzelle 3a gehörende Bitleitung 4a wird vorzugsweise durch kurzzeitiges Zuschalten der Spannungsquelle U2 mittels der Schaltelemente 8a und 21 auf eine zweite Spannung, beispielsweise 1 Volt, gezogen. Durch die Regelschaltung 1, die im vorliegenden Ausführungsbeispiel aus einem Operationsverstärker 1a und einem Transistor, beispielsweise einen pMOS-Längstransistor 22 besteht, wird die auszulesende Speicherzelle 3a auf diesem Spannungswert unabhängig vom Zellstrom gehalten, da an einem weiteren Eingang des Operationsverstärkers 1a eine Spannungsquelle U5 angelegt ist, die eine zu U2 möglichst identische Spannung liefert. Während der Source -Bereich des Transistors 22 die Bitleitungsspannung auf einem konstanten Wert von im vorliegenden Fall 1 Volt hält, weist der Drain-Bereich eine vom Widerstand der auszulesenden Speicherzelle abhängige variable Spannung auf, da der in Abhängigkeit vom Magnetisierungszustand vorhandene Widerstand der auszulesenden Speicherzelle 3a den Strom dieser Speicherzelle definiert, welcher auch durch den Transistor 22 und den Widerstand R1, beziehungsweise R2, der Bewerterschaltung fließt. Damit ruft dieser Strom am Abschlußwiderstand R1, R2 der Bewerterschaltung einen vom Zellwiderstand abhängigen Spannungsabfall hervor, wobei diese Spannung hier identisch ist mit der Drainspannung des Transistors 22.

Diese Spannung kann entweder im Spannungsbewerter 2 sofort bewertet werden oder mittels der in Figur 1 dargestellten Kondensatoren C1 und C2 zwischengespeichert werden, wobei bei einem Mehrfachlesevorgang zunächst sinnvollerweise auf die Kapazität C1 zurückgegriffen wird.

Nicht angesprochene Wortleitungen 5b werden über die vierte Spannungsquelle U4 und einen Spannungsverteiler 16 mittels Schaltelement 7b auf einer Spannung gehalten, die im wesentlichen der zweiten Spannung entspricht, also beispielsweise 1 Volt, wie sie von der zweiten Spannungsquelle U2 bereitgestellt wird. Nicht angesprochene Bitleitungen 4b werden über einen zweiten Spannungsverteiler 15 und Schaltelemente 9b mittels einer dritten Spannungsquelle U3 auf einem Spannungsniveau von im wesentlichen der ersten Spannung, beispielsweise 2 Volt gehalten. Wie ersichtlich, liegen somit alle Bit- und Wortleitungen auf festen Pegeln. Dieses Konzept ist somit einfach aufgebaut und die Funktionsfähigkeit daher gegeben.

Falls erfindungsgemäß nur ein Bewertungsvorgang durchgeführt werden soll, wird der erste Kondensator C1 zum Zwischenspeichern der Spannung nicht benötigt. In diesem Fall kann der Strom, die Spannung oder eine sonstige abgeleitete Größe sofort mittels eines Bewerters 2, der an die Bewerterleitung 10 angeschlossen und ansonsten mit der ersten Kapazität C1 parallel geschaltet ist (d.h. beide liegen an denselben Potentialen), bestimmt werden.

Ein Schreibvorgang, beispielsweise bei einem Umschaltversuch, erfolgt, indem zunächst die Spannungsquellen U3 und U4 an alle Wort- und Bitleitungen angelegt werden. Das Einprägen des Stromes über die Stromquellen I1 und I2 erfolgt durch Aufschalten der Stromquellen mittels der Schaltelemente 18 und 20, während zu diesem Zeitpunkt sowohl der Bewerterkomplex mittels Schaltelement 19 als auch die erste Lesespannungsquelle U1 mittels des Schaltelements 17 wie auch die Spannungsquelle U2 mittels Schaltelement 21 von der Speicherzellenanordnung getrennt sind. Die Stromstärken der Stromquellen I1 und I2 liegen z.B. jeweils bei ca. 1 mA. Die Ströme werden von den Schreibstromquellen I1 und I2 auf die Wortleitung 5a und die Bitleitung 4a geprägt und von den Spannungsquellen U3 und U4 aufgenommen.

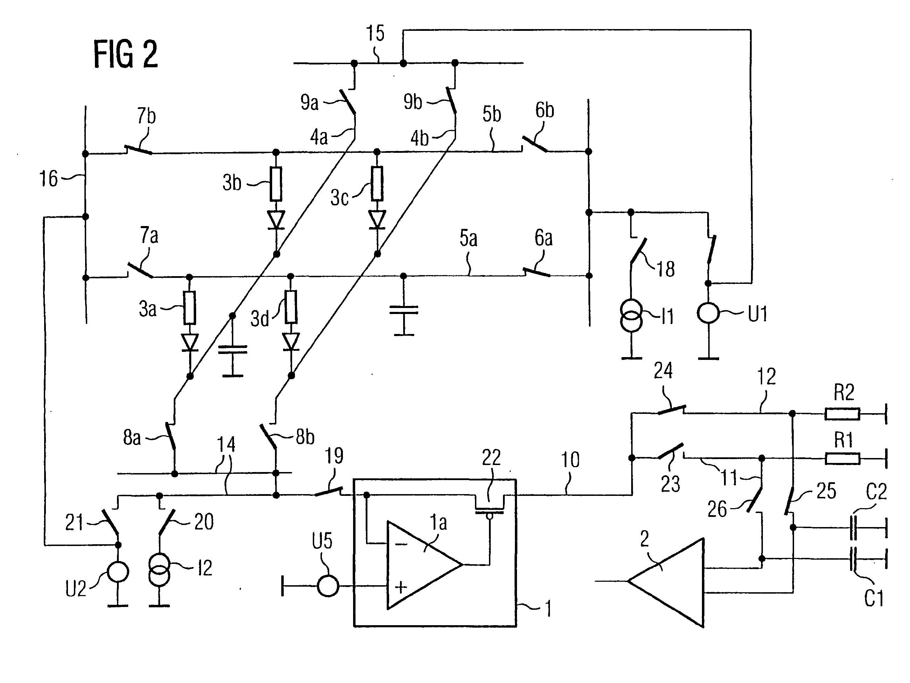

Fig.2 zeigt eine weitere Ausführungsform der vorliegenden Erfindung, bei der die Spannungsquellen U1 und U3 bzw U2 und U4, welche jeweils in etwa gleiche Spannungen aufweisen, zusammengefasst sind zu gemeinsamen Spannungsquellen U1 und U2. Ansonsten entspricht die in Fig. 2 gezeigte Schaltung und ihre Funktionsweise dem obigen Ausführungsbeispiel, wie es in Fig.1 gezeigt ist. Auch die Spannungsquelle U5 ist auf diese Weise integrierbar, d.h., sie kann im vorliegenden Ausführungsbeispiel entfallen, wenn der dritte Pol der Regelschaltung direkt mit der Vorladequelle U2 verbunden wird.

Bezugszeichenliste

| | |
|---|---|
| C1 | Erste Kapazität |
| C2 | Zweite Kapazität |
| R1 | Erster Abschlußwiderstand |
| R2 | Zweiter Abschlußwiderstand |
| U1 | Erste Lesespannungsquelle |
| U2 | Zweite Lesespannungsquelle |
| U3 | Dritte Spannungsquelle |
| U4 | Vierte Spannungsquelle |
| U5 | Fünfte Spannungsquelle |
| I1 | Erste Schreibstromquelle |
| I2 | Zweite Schreibstromquelle |
| 1 | Regelschaltung |
| 1a | Operationsverstärker |
| 2 | Spannungsbewerter |
| 3a,3b, 3c, 3d | magnetoresistive Speicherzellen |
| 4a,4b | Bitleitungen |
| 5a,5b | Wortleitungen |
| 6a, 6b | Schaltelemente zur Verbindung der Wortleitungen mit Lesespannungsquelle, Schreibstromquelle |
| 7a, 7b | Schaltelemente zur Verbindung der Wortleitungen mit vierter Spannungsquelle |
| 8a, 8b | Schaltelemente zur Verbindung der Bitleitungen mit Spannungsbewerter, Schreibstromquelle |

| 9a, 9b | Schaltelemente zur Verbindung der Bitleitungen mit dritter Spannungsquelle |
|---|---|
| 10 | Bewerterleitung/Anschlußleitung |
| 11 | Erster Bewerterpfad |
| 12 | Zweiter Bewerterpfad |
| 13 | Lesespannungsverteiler |
| 14 | Leseverteiler |
| 15, | 16 Spannungsverteiler |
| 17 | Schaltelement zur Verbindung von Lesespannungsquelle mit Leseverteiler |
| 18 | Schaltelement zur Verbindung von erster Schreibstromquelle mit Leseverteiler |
| 19 | Schaltelement zur Verbindung von Bewerterleitung mit Leseverteiler |
| 20 | Schaltelement zur Verbindung von zweiter Schreibstromquelle mit Bewerterverteiler |
| 21 | Schaltelement zur Verbindung von zweiter Lesespannungsquelle mit Bewerterverteiler |
| 22 | Bewertungs-Transistor |
| 23 | Schaltelement zur Verbindung von erstem Bewerterpfad mit Anschlußleitung |
| 24 | Schaltelement zur Verbindung von zweitem Bewerterpfad mit Anschlußleitung |
| 25 | Schaltelement zur Verbindung von zweitem Bewerterpfad mit Spannungsbewerter und zweiter Kapazität |
| 26 | Schaltelement zur Verbindung von erstem Bewerterpfad mit Spannungsbewerter und erster Kapazität |

**Patentansprüche**

1. Magnetoresistiver Speicher mit
   einer Anordnung von in einer Mehrzahl von Reihen und/oder einer Mehrzahl von Spalten angeordneten magnetoresistiven Speicherzellen (3a, b, c, d) mit einem Widerstand und einer Diodenfunktion;
   einer Bitleitung (4a, b) für jede der Spalten, die mit ersten Polen der zu der Spalte gehörenden Speicherzellen (3a, b, c, d) verbunden ist;
   einer Wortleitung (5a, b) für jede der Reihen, die mit zweiten Polen der zu der Reihe gehörenden Speicherzellen (3a, b, c, d) verbunden ist;
   einer ersten Lesespannungsquelle (U1) mit einer ersten Spannung, die mit ersten Enden der Wortleitungen durch Schaltelemente (6a, 6b, 17) einzeln verbindbar ist;
   **gekennzeichnet durch**
   eine Regelschaltung (1) mit
   einem ersten Pol, welcher über einen Leseverteiler (14) durch Schaltelemente (8a, 8b) mit ersten Enden der Bitleitungen (4a, 4b) einzeln verbindbar ist;
   einem zweiten Pol, aus welchem Strom in einen Bewerter (2) einspeisbar ist oder eingespeist wird; und
   einem dritten Pol, welcher mit einer Referenzspannungsquelle (U5) verbunden ist;
   eine dritte Spannungsquelle (U3) mit einer Spannung, die in etwa gleich der Spannung der ersten Lesespannungsquelle (U1) ist und welche über Schaltelemente (9a, 9b) mit zweiten Enden der Bitleitungen (4a, 4b) einzeln verbindbar ist; und
   eine vierte Spannungsquelle (U4), welche über Schaltelemente (7a, 7b) mit zweiten Enden der Wortleitungen (5a, 5b) einzeln verbindbar ist;
   wobei die Spannung der Referenzspannungsquelle (U5) und die Regelschaltung (1) so ausgelegt sind, daß am ersten Pol eine Spannung anliegt, die in etwa der Spannung der vierten Spannungsquelle (U4) entspricht; und der **durch** den zweiten Pol der Regelschaltung (1) fliessende Strom in etwa gleich dem durch den ersten Pol der Regelschaltung (1) fliessenden Strom ist und dieser Strom unabhängig von der am zweiten Pol der Regelschaltung (1) anliegenden Spannung ist.

2. Magnetoresistiver Speicher nach Anspruch 1, **dadurch gekennzeichnet, daß** der Bewerter (2) mit einem Eingang über eine Bewerterleitung (10) mit dem zweiten Pol der Regelschaltung (1) verbunden oder verbindbar ist; wobei von der Bewerterleitung (10) ein erster linearer oder nicht linearer Abschlußwiderstand (R1) abzweigt.

3. Magnetoresistiver Speicher nach Anspruch 1 oder 2, **dadurch gekennzeichnet, daß** der Bewerter (2) ein Spannungsbewerter ist und die von ihm bewertete Spannung abhängig von, beispielsweise proportional zu dem durch den zweiten Pol der Regelschaltung (1) fliessenden Strom ist.

4. Magnetoresistiver Speicher nach einem der Ansprüche 1 bis 3, **dadurch gekennzeichnet, daß** die Regelschaltung (1) einen Operationsverstärker mit zwei Eingängen aufweist, dessen nicht invertierter Eingang als dritter Pol mit der Referenzspannungsquelle (U5) verbunden ist und dessen invertierter Eingang als erster Pol mit den ersten Enden der Bitleitungen einzeln verbindbar ist, wobei der Operationsverstärker einen Ausgang aufweist, der mit dem Gate-Bereich eines Transistors mit zwei Source/Drain-Bereichen verbunden ist, dessen einer Source/Drain-Bereich mit dem invertierten Eingang des Operationsverstärkers verbunden ist und dessen anderer Source/Drain-Bereich als zweiter Pol Strom in den Bewerter (2) einspeist, und wobei die am ersten Pol anliegende Spannung gleich der am dritten Pol angelegten Spannung ist.

5. Magnetoresistiver Speicher nach einem der Ansprüche 1 bis 4, **dadurch gekennzeichnet, daß** die Referenzspannungsquelle (U5) zugleich die vierte Spannungsquelle (U4) ist.

6. Magnetoresistiver Speicher nach einem der Ansprüche 1 bis 4, **dadurch gekennzeichnet, daß** die Regelschaltung (1) einen bipolaren Transistor aufweist, dessen Basis als dritter Pol der Regelschaltung (1) mit der Referenzspannungsquelle (U5) verbunden ist, dessen Emitter als erster Pol der Regelschaltung (1) mit den ersten Enden der Bitleitungen einzeln verbindbar ist und dessen Kollektor als zweiter Pol der Regelschaltung (1) Strom in den Bewerter (2) einspeist.

7. Magnetoresistiver Speicher nach einem der Ansprüche 1 bis 6, **dadurch gekennzeichnet, daß** die erste Spannungsquelle (U1) zugleich die dritte Spannungsquelle (U3) ist.

8. Magnetoresistiver Speicher nach einem der Ansprüche 1 bis 7, **dadurch gekennzeichnet, daß** die Referenzspannung kleiner ist als die erste Spannung.

9. Magnetoresistiver Speicher nach einem der Ansprüche 1 bis 8, **dadurch gekennzeichnet, daß** die Spannungsdifferenz hinreichend ist, um bei gegebenem Widerstand in der auszulesenden Speicherzelle (3a) und Ansprechspannung der Diodenfunktion einen hinreichenden Stromfluß durch die auszulesende Speicherzelle (3a) zu erzielen.

10. Magnetoresistiver Speicher nach einem der Ansprüche 1 bis 9, **dadurch gekennzeichnet, daß** die Dioden der magnetoresistiven Speicherzellen (3a, b, c, d) so orientiert sind, daß beim Anlegen der ersten Spannung und der Referenzspannung ein Strom durch die auszulesende Speicherzelle (3a) fliessen kann.

11. Magnetoresistiver Speicher nach einem der Ansprüche 1 bis 10, **dadurch gekennzeichnet, daß** eine Vorladequelle (U2) mit dem Leseverteiler (14) verbindbar ist.

12. Magnetoresistiver Speicher nach Anspruch 11, **dadurch gekennzeichnet, daß** die Spannung der Vorladequelle (U2) im wesentlichen gleich der am ersten Pol der Regelschaltung anliegenden Spannung ist.

13. Magnetoresistiver Speicher nach Anspruch 11 oder 12, **dadurch gekennzeichnet, daß** die Vorladequelle (U2) zugleich die vierte Spannungsquelle (U4) ist.

14. Magnetoresistiver Speicher nach einem der Ansprüche 2 bis 13, **dadurch gekennzeichnet, daß** die Bewerterleitung (10) zwei Bewerterpfade (11, 12) aufweist, die durch Schaltelemente (20, 21) mit dem zweiten Pol der Regelschaltung (1) einzeln verbindbar sind;
wobei von den Bewerterpfaden (11, 12) je ein Abschlußwiderstand (R1, R2) abzweigt; und
wobei jeder der beiden Bewerterpfade (11, 12) durch ein Schaltelement (24, 25) mit einem Eingang des Spannungsbewerters (2) und einer dazu parallelen Kapazität (C1, C2) verbindbar ist.

15. Magnetoresistiver Speicher nach einem der Ansprüche 1 bis 14, **dadurch gekennzeichnet, daß** er weiterhin aufweist:

eine erste Schreibstromquelle (I1), die mit den ersten Enden der Wortleitungen (5a, 5b) durch Schaltelemente (6a, 6b, 17) einzeln verbindbar ist; und
eine zweite Schreibstromquelle (I2), die mit den ersten Enden der Bitleitungen (4a, 4b) durch Schaltelemente (8a, 8b, 18) einzeln verbindbar ist.

16. Magnetoresistiver Speicher nach Anspruch 15, **dadurch gekennzeichnet, daß** die Verbindung der Bitleitungen (4a, 4b) mit der Vorladequelle (U2) ebenfalls durch den Leseverteiler (14) erfolgt, wobei Vorladequelle (U2) und Regelschaltung (1) durch Schaltelemente (19, 21) mit dem Leseverteiler (14) verbindbar sind.

**17.** Magnetoresistiver Speicher nach einem der Ansprüche 1 bis 16, **dadurch gekennzeichnet, daß** die Verbindungen der dritten und vierten Spannungsquellen (U3, U4) mit den Bit-und Wortleitungen (4a, 4b, 5a, 5b) durch Spannungsverteiler (15, 16) mit einem Schaltelement (7a, 7b, 9a, 9b) für jede Bit- und Wortleitung (4a, 4b, 5a, 5b) erfolgen.

**18.** Magnetoresistiver Speicher nach einem der Ansprüche 1 bis 17, **dadurch gekennzeichnet, daß** die Verbindung der ersten Lesespannungsquelle (U1) mit den Wortleitungen (5a, 5b) durch einen Lesespannungsverteiler (13) mit einem Schaltelement (6a, 6b) für jede Wortleitung (5a, 5b) erfolgt.

**19.** Magnetoresistiver Speicher nach Anspruch 18, **dadurch gekennzeichnet, daß** die Verbindung der ersten Schreibstromquelle (I1) mit den Wortleitungen (5a, 5b) ebenfalls durch den Lesespannungsverteiler (13) erfolgt, wobei erste Schreibstromquelle (I1) und erste Lesespannungsquelle (U1) durch Schaltelemente (16, 17) mit dem Lesespannugsverteiler (13) verbindbar sind.

**20.** Verfahren zum Auslesen von Speicherzellen in einem magnetoresistiven Speicher mit

einer Anordnung von in einer Mehrzahl von Reihen und/oder einer Mehrzahl von Spalten angeordneten magnetoresistiven Speicherzellen (3a, 3b, 3c, 3d) mit einem Widerstand und einer Diodenfunktion; einer Bitleitung (4a, 4b) für jede der Spalten, die mit ersten Polen der zu der Spalte gehörenden Speicherzellen (3a, b; 3c, d) verbunden ist; einer Wortleitung (5a, 5b) für jede der Reihen, die mit zweiten Polen der zu der Reihe gehörenden Speicherzellen (3a, c; 3b, d) verbunden ist; und einer Referenzspannungsquelle (U5) mit einer Referenzspannung die mit dem dritten Pol einer Regelschaltung (1) verbunden ist, deren erster Pol mit dem ersten Pol der auszulesenden Speicherzelle (3a) verbunden ist, wobei die Regelschaltung eine am ersten Pol anliegende Spannung erzeugt, welche in einer definierten Funktion zu der Referenzspannung am dritten Pol der Regelschaltung (1) steht; wobei das Verfahren folgende Schritte aufweist:

A: Anlegen einer ersten Lesespannungsquelle (U1) mit einer ersten, von der Referenzspannung verschiedenen Spannung an den zweiten Pol einer auszulesenden Speicherzelle (3a);
B: Anlegen einer dritten Spannungsquelle (U3) mit einer Spannung, die in etwa gleich der ersten Spannung ist, an diejenigen Bitleitungen (4b), welche nicht mit der auszulesenden Speicherzelle (3a) verbunden sind;
C: Anlegen einer vierten Spannungsquelle (U4) mit einer Spannung, die in etwa gleich der am ersten Pol der Regelschaltung anliegenden Spannung ist, an diejenigen Wortleitungen (5b), welche nicht mit der auszulesenden Speicherzelle (3a) verbunden sind;
D: Bewerten des durch einen zweiten Pol der Regelschaltung und die auszulesende Speicherzelle (3a) fließenden Stroms oder einer davon abgeleiteten Größe durch einen Bewerter, in welchen aus dem zweiten Pol der Regelschaltung (1) Strom eingespeist wird.

**21.** Verfahren nach Anspruch 20, **dadurch gekennzeichnet, daß** die am ersten Pol der Regelschaltung anliegende Spannung gleich der Referenzspannung am dritten Pol der Regelschaltung (1) ist.

**22.** Verfahren nach Anspruch 20 oder 21, **dadurch gekennzeichnet, daß** die abgeleitete Größe eine über einen ersten Abschlußwiderstand (R1) abfallenden Spannung ist und mit einem zum ersten Abschlußwiderstand (R1) parallelen Spannungsbewerter (2) bewertet wird, wobei die Spannung proportional dem Strom ist, welcher durch die auszulesende Speicherzelle (3a) fließt.

**23.** Verfahren nach einem der Ansprüche 20 bis 22, **dadurch gekennzeichnet, daß** die Schritte A bis D im wesentlichen gleichzeitig ausgeführt werden.

**24.** Verfahren nach einem der Ansprüche 20 bis 23, **dadurch gekennzeichnet, daß** es folgende Schritte aufweist:

vor Schritt D, C, oder B:

A2: Anlegen einer Vorladequelle (U2), deren Spannung im wesentlichen gleich der am ersten Pol der Regelschaltung (1) anliegenden Spannung ist, an die mit dem ersten Pol der auszulesenden Speicherzelle (3a) verbundene Bitleitung (4a); und

nach Schritt A2 und vor Schritt D, C, oder B:

A3: Trennen der Vorladequelle (U2) von der mit dem ersten Pol der auszulesenden Speicherzelle (3a) verbundenen Bitleitung (4a).

**25.** Verfahren nach einem der Ansprüche 21 bis 24, **dadurch gekennzeichnet, daß** es folgende weitere Schritte aufweist:

E: Speichern der über den ersten Abschlußwiderstand (R1) abfallenden Spannung in einer ersten Kapazität (C1), die mit dem Spannungsbewerter (2) parallel geschaltet ist;

F: Trennen der ersten Kapazität (C1) vom ersten Abschlußwiderstand (R1) und von dem zweiten Pol der Regelschaltung (1) ;

G: Trennen der ersten Lesespannungsquelle (U1) von der auszulesenden Speicherzelle (3a);

H: Trennen der Regelschaltung (1) von der auszulesenden Speicherzelle (3a);

I: Anlegen der an der vierten Spannungsquelle (U4) anliegenden Spannung an alle Wortleitungen (5a, 5b);

J: Anlegen der an der dritten Spannungsquelle (U3) anliegenden Spannung an alle Bitleitungen (4a, 4b);

K: Anlegen einer ersten Stromquelle (I1) an die mit dem zweiten Pol der auszulesenden Speicherzelle (3a) verbundene Wortleitung (5a);

L: Anlegen einer zweiten Stromquelle (I2) an die mit dem zweiten Pol der auszulesenden Speicherzelle (3a) verbundene Bitleitung (4a);

M: Trennen der ersten Stromquelle (I1) von der mit dem zweiten Pol der auszulesenden Speicherzelle (3a) verbundenen Wortleitung (5a);

N: Trennen der zweiten Stromquelle (I2) von der mit dem ersten Pol der auszulesenden Speicherzelle (3a) verbundenen Bitleitung (4a);

○: Anlegen der ersten Lesespannungsquelle (U1) an den zweiten Pol der auszulesenden Speicherzelle (3a);

P: Verbinden des ersten Pols der Regelschaltung mit der auszulesenden Speicherzelle;

Q: Anlegen der dritten Spannungsquelle (U3) an diejenigen Bitleitungen (4b), welche nicht mit der auszulesenden Speicherzelle (3a) verbunden sind;

R: Anlegen der vierten Spannungsquelle (U4) an diejenigen Wortleitungen (5b), welche nicht mit der auszulesenden Speicherzelle (3a) verbunden sind;

S: Verbinden des zweiten Pols der Regelschaltung (1) mit einem zweiten Abschlußwiderstand (R2); einer zum zweiten Abschlußwiderstand parallelen zweiten Kapazität (C2); und einem dazu parallelen zweiten Eingang des Spannungsbewerters (2) ;

T: Speichern der über den zweiten Abschlußwiderstand (R2) abfallenden Spannung in der zweiten Kapazität (C2);

U: Trennen der zweiten Kapazität (C2) vom zweiten Abschlußwiderstand (R2) und von dem zweiten Pol der Regelschaltung (1); und

V: Vergleichen der in der ersten und der zweiten Kapazität (C1, C2) gespeicherten Spannung im Spannungsbewerter (2).

**26.** Verfahren nach einem der Ansprüche 20 bis 25, **dadurch gekennzeichnet, daß** die Referenzpannung kleiner ist als die erste Spannung.

**27.** Verfahren nach einem der Ansprüche 20 bis 26, **dadurch gekennzeichnet, daß** die Spannungsdifferenz hinreichend ist, um bei gegebenem Widerstand in der auszulesenden Speicherzelle (3a) und Ansprechspannung der Diodenfunktion einen hinreichenden Stromfluß durch die auszulesende Speicherzelle (3a) zu erzielen.

**Claims**

**1.** Magnetoresistive memory having

an arrangement of magnetoresistive memory cells (3a, b, c, d) which are arranged in two or more rows and/or two or more columns, with a resistor and a diode function;

a bit line (4a, b) for each of the columns which is connected to first poles of the memory cells (3a, b, c, d) which belong to that column;

a word line (5a, b) for each of the rows, which is connected to second poles of the memory cells (3a, b, c, d) which belong to that row; and

a first read voltage source (U1) having a first voltage, which can be connected individually to first ends of the word lines by means of switching elements (6a, 6b, 17)

**characterized by**

a control circuit (1), having

a first pole which can be connected individually via a read distributor (14) by means of switching elements (8a, 8b) to first ends of the bit lines (4a, 4b);

a second pole, from which current can be or is fed into an assessment device (2); and

a third pole, which is connected to a reference voltage source (U5);

a third voltage source (U3) having a voltage which is approximately the same as the voltage from the first read voltage source (U1) and which can be connected individually via switching elements (9a, 9b) to second ends of the bit lines (4a, 4b); and

a fourth voltage source (U4), which can be connected individually via switching elements (7a, 7b) to second ends of the word lines (5a, 5b);

with the voltage of the reference voltage source (U5) and the control circuit (1) being designed such that a voltage is present at the first pole which corresponds approximately to the voltage from the fourth voltage source (U4); and the current flowing through the second pole of the control circuit (1) is approximately the same as the current flowing through the first pole of the control circuit (1), and this current is independent of the voltage which is present at the second pole of the control circuit (1).

2.  Magnetoresistive memory according to Claim 1, **characterized in that** one input of the assessment device (2) is connected or can be connected via an assessment device line (10) to the second pole of the control circuit (1); with a first linear or non-linear terminating resistor (R1) branching off from the assessment device line (10).

3.  Magnetoresistive memory according to Claim 1 or 2, **characterized in that** the assessment device (2) is a voltage assessment device, and the voltage which is assessed by it is dependent on, for example proportional to, the current flowing through the second pole of the control circuit (1).

4.  Magnetoresistive memory according to one of Claims 1 to 3, **characterized in that** the control circuit (1) has an operational amplifier with two inputs, whose noninverted input is connected as a third pole to the reference voltage source (U5), and whose inverted input can be connected, as a first pole, individually to the first ends of the bit lines, with the operational amplifier having an output which is connected to the gate region of a transistor with two source/drain regions, one of whose source/drain regions is connected to the inverted input of the operational amplifier, and whose other source/drain region, as a second pole, feeds current to the assessment device (2), and with the voltage which is present at the first pole being the same as the voltage which is present at the third pole.

5.  Magnetoresistive memory according to one of Claims 1 to 4, **characterized in that** the reference voltage source (U5) is at the same time the fourth voltage source (U4).

6.  Magnetoresistive memory according to one of Claims 1 to 4, **characterized in that** the control circuit (1) has a bipolar transistor whose base is connected, as a third pole of the control circuit (1), to the reference voltage source (U5), whose emitter can be connected, as a first pole of the control circuit (1), individually to the first ends of the bit lines, and whose collector, as a second pole of the control circuit (1), feeds current to the assessment device (2).

7.  Magnetoresistive memory according to one of Claims 1 to 6, **characterized in that** the first voltage source (U1) is at the same time the third voltage source (U3).

8.  Magnetoresistive memory according to one of Claims 1 to 7, **characterized in that** the reference voltage is less than the first voltage.

9.  Magnetoresistive memory according to one of Claims 1 to 8, **characterized in that** the voltage difference is sufficient to achieve a sufficient current flow through the memory cell (3a) that is to be read, for a given resistance in the memory cell (3a) which is to be read and response voltage of the diode function.

10. Magnetoresistive memory according to one of Claims 1 to 9, **characterized in that** the diodes of the magnetoresistive memory cells (3a, b, c, d) are oriented such that a current can flow through the memory cell (3a) which is to be read when the first voltage and the reference voltage are applied.

11. Magnetoresistive memory according to one of Claims 1 to 10, **characterized in that** a precharging source (U2) can be connected to the read distributor (14).

12. Magnetoresistive memory according to Claim 11, **characterized in that** the voltage of the precharging source (U2) is essentially the same as the voltage which is present at the first pole of the control circuit.

13. Magnetoresistive memory according to Claim 11 or 12, **characterized in that** the precharging source (U2) is at the same time the fourth voltage source (U4).

**14.** Magnetoresistive memory according to one of Claims 2 to 13, **characterized in that** the assessment device line (10) has two assessment device paths (11, 12) which can be connected individually by means of switching elements (20, 21) to the second pole of the control circuit (1);
with a terminating resistor (R1, R2) branching off from the respective assessment device paths (11, 12); and
in which case each of the two respective assessment device paths (11, 12) can be connected by means of a respective switching element (24, 25) to one input of the voltage assessment device (2) and to a respective capacitance (C1, C2) in parallel with it.

**15.** Magnetoresistive memory according to one of Claims 1 to 14, **characterized in that** the memory also has:

a first write current source (I1) which can be connected individually to the first ends of the word lines (5a, 5b) by means of switching elements (6a, 6b, 17); and
a second write current source (I2), which can be connected individually to the first ends of the bit lines (4a, 4b) by means of switching elements (8a, 8b, 18).

**16.** Magnetoresistive memory according to Claim 15, **characterized in that** the bit lines (4a, 4b) are likewise connected to the precharging source (U2) by means of the read distributor (14), in which case the precharging source (U2) and the control circuit (1) can be connected by means of switching elements (19, 21) to the read distributor (14).

**17.** Magnetoresistive memory according to one of Claims 1 to 16, **characterized in that** the third and fourth voltage sources (U3, U4) are connected to the bit lines and word lines (4a, 4b, 5a, 5b) by means of voltage distributors (15, 16) with a switching element (7a, 7b, 9a, 9b) for each bit line and word line (4a, 4b, 5a, 5b).

**18.** Magnetoresistive memory according to one of Claims 1 to 17, **characterized in that** the first read voltage source (U1) is connected to the word lines (5a, 5b) by means of a read voltage distributor (13) with a switching element (6a, 6b) for each word line (5a, 5b).

**19.** Magnetoresistive memory according to Claim 18, **characterized in that** the first write current source (I1) is likewise connected to the word lines (5a, 5b) by means of the read voltage distributor (13), in which case the first write current source (I1) and the first read voltage source (U1) can be connected by means of switching elements (16, 17) to the read voltage distributor (13).

**20.** Method for reading memory cells in a magnetoresistive memory having
an arrangement of magnetoresistive memory cells (3a, 3b, 3c, 3d) which are arranged in two or more rows and/or two or more columns, with a resistor and a diode function; a bit line (4a, 4b) for each of the columns which is connected to first poles of the memory cells (3a, b; 3c, d) which belong to that column; a word line (5a, 5b) for each of the rows, which is connected to second poles of the memory cells (3a, c; 3b, d) which belong to that row; and a reference voltage source (U5) with a reference voltage which is connected to the third pole of a control circuit (1), whose first pole is connected to the first pole of the memory cell (3a) which is to be read, with the control circuit producing a voltage which is present at the first pole and is related by a defined function to the reference voltage at the third pole of the control circuit (1);
with the method having the following steps:

A: application of a first read voltage source (U1) with a first voltage, which is not the same as the reference voltage, to the second pole of a memory cell (3a) which is to be read;
B: application of a third voltage source (U3) with a voltage which is approximately the same as the first voltage to those bit lines (4b) which are not connected to the memory cell (3a) which is to be read;
C: application of a fourth voltage source (U4) with a voltage which is approximately the same as the voltage which is present at the first pole of the control circuit to those word lines (5b) which are not connected to the memory cell (3a) which is to be read;
D: assessment of the current flowing through a second pole of the control circuit and the memory cell (3a) which is to be read, or assessment of a variable which is derived from this by an assessment device to which current is fed from the second pole of the control circuit (1).

**21.** Method according to Claim 20, **characterized in that** the voltage which is present at the first pole of the control circuit is the same as the reference voltage at the third pole of the control circuit (1).

**22.** Method according to Claim 20 or 21, **characterized in that** the derived variable is a voltage which is dropped across a first terminating resistor (R1) and is assessed by a voltage assessment device (2) which is connected in parallel with the first terminating resistor (R1), with the voltage being proportional to the current which is flowing through the memory cell (3a) that is to be read.

**23.** Method according to one of Claims 20 to 22, **characterized in that** steps A to D are carried out essentially at the same time.

**24.** Method according to one of Claims 20 to 23, **characterized in that** the method has the following steps:

before step D, C or B:

A2: application of a precharging source (U2), whose voltage is essentially the same as the voltage which is present at the first pole of the control circuit (1), to the bit line (4a) which is connected to the first pole of the memory cell (3a) which is to be read; and

after step A2 and before step D, C or B:

A3: disconnection of the precharging source (U2) from the bit line (4a) which is connected to the first pole of the memory cell (3a) which is to be read.

**25.** Method according to one of Claims 21 to 24, **characterized in that** the method has the following further steps:

E: storage of the voltage which is dropped across the first terminating resistor (R1) in a first capacitance (C1) which is connected in parallel with the voltage assessment device (2);
F: disconnection of the first capacitance (C1) from the first terminating resistor (R1) and from the second pole of the control circuit (1);
G: disconnection of the first read voltage source (U1) from the memory cell (3a) which is to be read;
H: disconnection of the control circuit (1) from the memory cell (3a) which is to be read;
I: application of the voltage which is present at the fourth voltage source (U4) to all the word lines (5a, 5b);
J: application of the voltage which is present at the third voltage source (U3) to all the bit lines (4a, 4b);
K: application of a first current source (I1) to the word line (5a) which is connected to the second pole of the memory cell (3a) which is to be read;
L: application of a second current source (I2) to the bit line (4a) which is connected to the second pole of the memory cell (3a) which is to be read;
M: disconnection of the first current source (I1) from the word line (5a) which is connected to the second pole of the memory cell (3a) which is to be read;
N: disconnection of the second current source (I2) from the bit line (4a) which is connected to the first pole of the memory cell (3a) which is to be read;
0: application of the first read voltage source (U1) to the second pole of the memory cell (3a) which is to be read;
P: connection of the first pole of the control circuit to the memory cell which is to be read;
Q: application of the third voltage source (U3) to those bit lines (4b) which are not connected to the memory cell (3a) which is to be read;
R: application of the fourth voltage source (U4) to those word lines (5b) which are not connected to the memory cell (3a) which is to be read;
S: connection of the second pole of the control circuit (1) to a second terminating resistor (R2); a second capacitance (C2) which is connected in parallel with the second terminating resistor; and a second input, which is connected in parallel with it, of the voltage assessment device (2);
T: storage of the voltage which is dropped across the second terminating resistor (R2) in the second capacitance (C2);
U: disconnection of the second capacitance (C2) from the second terminating resistor (R2) and from the second pole of the control circuit (1); and
V: comparison of the voltage which is stored in the first capacitance (C1) and in the second capacitance (C2) in the voltage assessment device (2).

**26.** Method according to one of Claims 20 to 25, **characterized in that** the reference voltage is less than the first voltage.

**27.** Method according to one of Claims 20 to 26, **characterized in that** the voltage difference is sufficient to achieve a sufficient current flow through the memory cell (3a) that is to be read, for a given resistance in the memory cell (3a) which is to be read and response voltage of the diode function.

**Revendications**

1. Mémoire magnétorésistive comprenant
un agencement de cellules (3a, b, c, d) de mémoire magnétorésistives disposées suivant une multiplicité de rangées et/ou une multiplicité de colonnes et ayant une résistance et une fonction de diode ;
une ligne (4a, b) de bits pour chacune des colonnes, qui est reliée à des premiers pôles des cellules (3a, b, c, d) de mémoire appartenant à la colonne ;
une ligne (5a, b) de mots pour chacune des rangées, qui est reliée à des deuxièmes pôles des cellules (3a, b, c, d) de mémoire appartenant à la rangée ;
une première source (U1) de tension de lecture, ayant une première tension et pouvant être reliée individuellement à de premières extrémités des lignes de mots pour des éléments (6a, 6b, 17) de commutation ;
**caractérisée par**
un circuit (1) de régulation comprenant
un premier pôle qui peut être relié individuellement, par un répartiteur (14) de lecture, en passant par des éléments (8a, 8b) de commutation, à des premières extrémités des lignes (4a, 4b) de bits ;
un deuxième pôle à partir duquel du courant peut être injecté ou est injecté dans un évaluateur (2) ; et
un troisième pôle qui est relié à une source (U5) de tension de référence ;
une troisième source (U3) de tension ayant une tension qui est à peu près égale à la tension de la première source (U1) de tension de lecture et qui peut être reliée individuellement par des éléments (9a, 9b) de commutation à des deuxièmes extrémités des lignes (4a, 4b) de bits ; et
une quatrième source (U4) de tension, qui peut être reliée individuellement par des éléments (7a, 7b) de commutation à des deuxièmes extrémités des lignes (5a, 5b) de mots ;
la tension de la source (U5) de tension de référence et le circuit (1) de régulation étant conçus de manière à appliquer au premier pôle une tension qui correspond à peu près à la tension de la quatrième source(U4) de tension ; et le courant passant dans le deuxième pôle du circuit (1) de régulation est à peu près égal au courant passant dans le premier pôle du circuit (1) de régulation et ce courant est indépendant de la tension s'appliquant au deuxième pôle du circuit (1) de régulation.

2. Mémoire magnétorésistive suivant la revendication 1, **caractérisée en ce que** l'évaluateur (2) est relié ou peut être relié par une entrée au moyen d'une ligne (10) d'évaluateur, au deuxième pôle du circuit (1) de régulation, une première résistance (R1) linéaire ou non de fermeture étant en dérivation de la ligne (10) d'évaluateur.

3. Mémoire magnétorésistive suivant la revendication 1 ou 2, **caractérisée en ce que** l'évaluateur (2) est un évaluateur de tension et la tension qu'il évalue est indépendante du courant allant, par exemple proportionnellement, au circuit (1) de régulation en passant par le deuxième pôle.

4. Mémoire magnétorésistive suivant l'une des revendications 1 à 3, **caractérisée en ce que** le circuit (1) de régulation comporte un amplificateur opérationnel ayant deux entrées, dont l'entrée non inversée est reliée en tant que troisième pôle à la source (U5) de tension de référence et dont l'entrée inversée peut être reliée individuellement en tant que premier pôle aux premières extrémités des lignes de bits, l'amplificateur opérationnel ayant une sortie qui est reliée à la zone de grille d'un transistor ayant deux zones de source/drain, dont l'une des zones de sources/drain est reliée à l'entrée inversée de l'amplificateur opérationnel et dont l'autre zone de source/drain injecte en tant que deuxième pôle du courant dans l'évaluateur (2) et la tension s'appliquant au premier pôle est égale à la tension appliquée au troisième pôle.

5. Mémoire magnétorésistive suivant l'une des revendications 1 à 4, **caractérisée en ce que** la source (U5) de tension de référence est en même temps la quatrième source (U4) de tension.

6. Mémoire magnétorésistive suivant l'une des revendications 1 à 4, **caractérisée en ce que** le circuit (1) de régulation comporte un transistor bipolaire dont la base est reliée en tant que troisième pôle du circuit (1) de régulation à la source (U5) de tension de référence, dont l'émetteur peut être relié individuellement en tant que premier pôle du circuit (1) de régulation aux premières extrémités des lignes de bits et dont le collecteur injecte en tant que deuxième pôle du circuit (1) de régulation du courant dans l'évaluateur (2).

**7.** Mémoire magnétorésistive suivant l'une des revendications 1 à 6, **caractérisée en ce que** la première source (U1) de tension est en même temps la troisième source (U3) de tension.

**8.** Mémoire magnétorésistive suivant l'une des revendications 1 à 7, **caractérisée en ce que** la tension de référence est plus basse que la première tension.

**9.** Mémoire magnétorésistive suivant l'une des revendications 1 à 8, **caractérisée en ce que** la différence de tension est suffisante pour obtenir, pour une résistance donnée dans la cellule (3a) de mémoire à lire et une tension d'activation de la fonction de diode, un flux de courant suffisant dans la cellule (3a) de mémoire à lire.

**10.** Mémoire magnétorésistive suivant l'une des revendications 1 à 9, **caractérisée en ce que** les diodes des cellules (3a, b, c, d) de mémoire magnétorésistive sont orientées de façon à ce que, lorsque la première tension et la tension de référence sont appliquées, un courant peut passer dans la cellule (3a) de lecture à lire.

**11.** Mémoire magnétorésistive suivant l'une des revendications 1 à 10, **caractérisée en ce qu'**une source (U2) de précharge peut être reliée au répartiteur (14) de lecture.

**12.** Mémoire magnétorésistive suivant la revendication 11, **caractérisée en ce que** la tension de la source (U2) de précharge est sensiblement égale à la tension s'appliquant au premier pôle du circuit de régulation.

**13.** Mémoire magnétorésistive suivant la revendication 11 ou 12, **caractérisée en ce que** la source (U2) de précharge est en même temps la quatrième source (U4) de tension.

**14.** Mémoire magnétorésistive suivant l'une des revendications 2 à 13, **caractérisée en ce que** la ligne (10) d'évaluateur a deux trajets (11, 12) d'évaluateur, qui peuvent être reliés individuellement par des éléments (20, 21) de commutation au deuxième pôle du circuit (1) de régulation ;
respectivement une résistance (R1, R2) de terminaison étant en dérivation des trajets (11, 12) d'évaluateur ; et chacun des deux trajets (11, 12) d'évaluateur pouvant être relié par un élément (24, 25) de commutation à une entrée de l'évaluateur (2) de tension et à une capacité (C1, C2) qui est montée en parallèle à celui-ci.

**15.** Mémoire magnétorésistive suivant l'une des revendications 1 à 14, **caractérisée en ce qu'**elle comprend en outre :

une première source (I1) de courant d'écriture, qui peut être reliée individuellement aux premières extrémités des lignes (5a, 5b) de mots par des éléments (6a, 6b, 17) de commutation ; et
une deuxième source (I2) de courant d'écriture, qui peut être reliée individuellement aux premières extrémités des lignes (4a, 4b) de bits par des éléments (8a, 8b, 18) de commutation.

**16.** Mémoire magnétorésistive suivant la revendication 15, **caractérisée en ce que** la liaison des lignes (4a, 4b) de bits à la source (U2) de précharge s'effectue également par le répartiteur (14) de lecture, la source (U2) de précharge et le circuit (1) de régulation pouvant être reliés au répartiteur (14) de lecture par des éléments (19, 21) de commutation.

**17.** Mémoire magnétorésistive suivant l'une des revendications 1 à 16, **caractérisée en ce que** les liaisons des troisième et quatrième sources (U3, U4) de tension aux lignes (4a, 4b, 5a, 5b) de bits et de mots s'effectuent par des répartiteurs (15, 16) de tension ayant un élément (7a, 7b, 9a, 9b) de commutation pour chaque ligne (4a, 4b, 5a, 5b) de bits et de mots.

**18.** Mémoire magnétorésistive suivant l'une des revendications 1 à 17, **caractérisée en ce que** la liaison entre la première source (U1) de tension de lecture et les lignes (5a, 5b) de mots s'effectue par un répartiteur (13) de tension de lecture ayant un élément (6a, 6b) de commutation pour chaque ligne (5a, 5b) de mots.

**19.** Mémoire magnétorésistive suivant la revendication 18, **caractérisée en ce que** la liaison entre la première source (I1) de courant d'écriture et les lignes (5a, 5b) de mots s'effectue également par le répartiteur (13) de tension de lecture, la première source (I1) de courant d'écriture et la première source (U1) de tension de lecture pouvant être reliées au répartiteur (13) de tension de lecture par des éléments (16, 17) de commutation.

**20.** Procédé de lecture de cellules de mémoire dans une mémoire magnétorésistive comprenant
un agencement de cellules (3a, 3b, 3c, 3d) de mémoire magnétorésistives disposées suivant une multiplicité de rangées et/ou une multiplicité de colonnes et ayant une résistance à une fonction de diode ; une ligne (4a, 4b) de bits pour chacune des colonnes qui est reliée à des premiers pôles des cellules (3a, b, 3c, d) de mémoire appartenant à la colonne ; une ligne (5a, 5b) de mots pour chacune des rangées qui est reliée à des deuxièmes pôles des cellules (3a, c, 3b, d) de mémoire appartenant à la rangée ; et une source (U5) de tension de référence ayant une tension de référence, qui est reliée au troisième pôle d'un circuit (1) de régulation dont le premier pôle est relié au premier pôle de la cellule (3a) de mémoire à lire, le circuit de régulation produisant une tension qui s'applique au première pôle et qui est dans une fonction définie par rapport à la tension de référence sur le troisième pôle du circuit (1) de régulation ;

le procédé ayant des stades suivants :

A : on applique une première source (U1) de tension de lecture, ayant une première tension différente de la tension de référence, au deuxième pôle d'une cellule (3a) de mémoire à lire ;

B : on applique une troisième source (U3) de tension, ayant une tension qui est à peu près égale à la première tension, aux lignes (4b) de bits qui ne sont pas reliées à la cellule (3a) de mémoire à lire ;

C : on applique une quatrième source (U4) de tension, ayant une tension qui est à peu près égale à la tension s'appliquant au premier pôle du circuit de régulation, aux lignes (5b) de mots qui ne sont pas reliées à la cellule (3a) de mémoire à lire ;

D : on évalue le courant passant dans un deuxième pôle du circuit de régulation et dans la cellule (3a) de mémoire à lire ou une grandeur qui en dérive par un évaluateur dans lequel on injecte du courant provenant du deuxième pôle du circuit (1) de régulation.

21. Procédé suivant la revendication 20, **caractérisé en ce que** la tension s'appliquant au premier pôle du circuit de régulation est égale à la tension de référence sur le troisième pôle du circuit (1) de régulation.

22. Procédé suivant la revendication 20 ou 21, **caractérisé en ce que** la grandeur dérivée est une tension chutant aux bornes d'une première résistance (R1) de terminaison et est évaluée par un évaluateur (2) de tension monté en parallèle à la première résistance (R1) de terminaison, la tension étant proportionnelle au courant qui passe dans la cellule (3a) de mémoire à lire.

23. Procédé suivant l'une des revendications 20 à 22, **caractérisé en ce que** l'on effectue sensiblement simultanément les stades A à D.

24. Procédé suivant l'une des revendications 20 à 23, **caractérisé en ce qu'**il comprend des stades suivants :

avant le stade D, C, ou B :

A2 : on applique une source (U2) de précharge, dont la tension est sensiblement égale à la tension s'appliquant au premier pôle du circuit (1) de régulation, à la ligne (4a) de bits reliée au premier pôle de la cellule (3a) de mémoire à lire ; et

Après le stade A2 et avant le stade D, C ou B :

A3 : on sépare la source (U2) de précharge de la ligne (4a) de bits reliée au premier pôle de la cellule (3a) de mémoire à lire.

25. Procédé suivant l'une des revendications 21 à 24, **caractérisé en ce qu'**il comprend d'autres stades suivants :

E : on emmagasine la tension chutant aux bornes de la première résistance (R1) de terminaison dans une capacité (C1) qui est montée en parallèle avec l'évaluateur (2) de tension ;

F : on sépare la première capacité (C1) de la première résistance (R1) de terminaison et du deuxième pôle du circuit (1) de régulation ;

G : on sépare la première source (U1) de tension de lecture de la cellule (3a) de mémoire à lire ;

H : on sépare le circuit (1) de régulation de la cellule (3a) de mémoire à lire ;

I : on applique à toutes les lignes (5a, 5b) de mots la tension s'appliquant à la quatrième source (U4) de tension.

J : on applique à toutes les lignes (4a, 4b) de bits la tension s'appliquant à la troisième source (U3) de tension.

K : on applique à une première source (I1) de courant à la ligne (5a) de mots reliée au deuxième pôle de la cellule (3a) de mémoire à lire.

L : on applique une deuxième source (I2) de courant à la ligne (4a) de bits reliée au deuxième pôle de la cellule (3a) de mémoire à lire.

M : on sépare la première source (I1) de courant de la ligne (5a) de mots reliée au deuxième pôle de la cellule (3a) de mémoire à lire.

N : on sépare la deuxième source (12) de courant de la ligne (4a) de bits reliée au premier pôle de la cellule (3a) de mémoire à lire.

○ : on applique la première source (U1) de tension de lecture au deuxième pôle de la cellule (3a) de mémoire à lire.

P : on relie le premier pôle du circuit de régulation à la cellule de mémoire à lire.

Q : on applique la troisième source (U3) de tension aux lignes (4b) de bits qui ne sont pas reliées à la cellule (3a) de mémoire à lire.

R : on applique la quatrième source (U4) de tension aux lignes (5b) de mots qui ne sont pas reliées à la cellule (3a) de mémoire à lire.

S : on relie le deuxième pôle du circuit (1) de régulation à une deuxième résistance (R2) de terminaison ; à une deuxième capacité (C2) en parallèle à la deuxième résistance de terminaison, et à une deuxième entrée en parallèle à cela de l'évaluateur (2) de tension.

T : on emmagasine dans la deuxième capacité (C2) la tension chutant aux bornes de la deuxième résistance (R2) de terminaison.

U : on sépare la deuxième capacité (C2) de la deuxième résistance (R2) de terminaison et du deuxième pôle du circuit (1) de régulation ; et

V : on compare dans l'évaluateur (2) de tension la tension emmagasinée dans la première et dans la deuxième capacités (C1, C2).

26. Procédé suivant l'une des revendications 20 à 25, **caractérisé en ce** la tension de référence est plus basse que la première tension.

27. Procédé suivant l'une des revendications 20 à 26, **caractérisé en ce que** la différence de tension est suffisante pour obtenir, pour une résistance donnée dans la cellule (3a) de mémoire à lire et une tension d'activation de la fonction de diode, un flux de courant suffisant dans la cellule (3a) de mémoire à lire.

FIG 1

EP 1 340 230 B1

FIG 2